# EUROPÄISCHE PATENTANMELDUNG

(11) **EP 1 849 885 A1**
(43) Veröffentlichungstag der Anmeldung: **31.10.2007**
(21) Anmeldenummer: 06113329.4
(22) Anmeldetag: 28.04.2006
(51) Int. Cl.: C23C 14/20, C23C 14/02, C23C 14/56, H01G 4/015

(54) **Metallisierung mittels dünner, mit Plasmaunterstützung abgeschiedener Impfschicht**

(71) Anmelder: Applied Materials GmbH & Co. KG, 63755 Alzenau (DE)
(72) Erfinder: Olbrich, Peter, 35463, Fernwald-Annerod (DE); Hoffmann, Gerd, 63486, Bruchköbel (DE); Klemm, Günter, 61667, Nidda (DE)
(74) Vertreter: Lang, Christian

(57) **Zusammenfassung**

Die vorliegende Erfindung betrifft ein Verfahren zur Herstellung metallisierter Bahnen (3), insbesondere metallisierter Kunststoffbahnen für Folienkondensatoren, bei welchen eine Metallschicht (17) über eine Dampf- oder Gasphase aufgebracht wird, wobei vor dem Aufbringen der Metallschicht eine plasmaunterstützte Dampf- oder Gasphasenabscheidung einer metallischen Impfschicht erfolgt, deren Dicke im Bereich von bis zu wenigen Atomlagen Iiegt. Ferner betrifft die vorliegende Erfindung eine entsprechend hergestellte Kunststofffolie mit einer bis zu einigen wenigen Atomlagen dicken Impfschicht zwischen Metallschicht und Kunststofffolie.

## Beschreibung

### Technisches Gebiet

Die vorliegende Erfindung betrifft ein Verfahren und eine Vorrichtung zur Herstellung metallisierter Bahnen, insbesondere metallisierter Kunststoffbahnen für Folienkondensatoren, bei welchem eine Metallschicht über eine Dampf- oder Gasphase aufgebracht wird, bzw. eine entsprechende metallisierte Kunststofffolie.

### Stand der Technik

Metallisierte Kunststofffolien werden in der Technik beispielsweise als Kondensatorfolien eingesetzt. Derartige Kondensatorfolien bestehen aus einer nicht leitenden Kunststofffolie, beispielsweise aus Polyester oder Polypropylen, auf der zur Bildung der Elektroden Metallschichten aus Zink aufgebracht werden. Üblicherweise erfolgt dies beispielsweise in einer Bandbeschichtungsanlage, bei der das zu beschichtende Kunststoffmaterial von einer Rolle abgewickelt, durch die Beschichtungsstation hindurchgeführt und auf einer zweiten Rolle wieder aufgewickelt wird.

Die Beschichtungsstation wird meist durch eine thermische Verdampfungseinheit gebildet, bei welcher das auf die Kunststofffolie aufzubringende Material durch entsprechende Wärmeeinwirkung verdampft wird, so dass beim Hindurchbewegen der Kunststofffolie durch die Metalldampfwolke sich entsprechendes Material ablagert.

Üblicherweise wird als Elektrodenmaterial Zink verwendet.

Um eine gleichmäßige und gut haftende Metall- bzw. Zinkschicht zu erhalten, wird in bekannter Weise eine Impf- bzw. Keimschicht vorzugsweise aus Aluminium auf der Kunststofffolie abgeschieden, bevor die eigentliche Metallschicht aufgebracht wird. Die Impf- bzw. Keimschicht kann ebenfalls durch thermische Verdampfung aufgebracht werden. Üblicherweise beträgt der Anteil der Impf- bzw. Keimschicht an der Gesamtschicht bzw. Schichtdicke 5 bis 10 %.

Dies ist jedoch insbesondere für die Selbstheilungseigenschaften von Zink-Schichten bei Folienkondensatoren nachteilhaft, da diese Selbstheilungseigenschaft durch eine dicke Impf- bzw. Keimschicht negativ beeinflusst wird. Die Selbstheilungseigenschaft beruht nämlich auf der geringen Verdampfungsenergie der Zinkschicht, die bei Verwendung einer Impf- bzw. Keimschicht aus einem Metall mit höherer Kondensationsenergie, wie beispielsweise Aluminium dazu führt, dass die Verdampfung bzw. das Aufschmelzen des Metalls bei Ausbildung einer Fehlstelle, d.h. eines Kurzschlusses verschlechtert wird. Entsprechend wäre es alleine für die Selbstheilungseigenschaft vorteilhaft keine Impf- bzw. Keimschicht vorzusehen.

Dies kann beispielsweise dadurch erreicht werden, dass die Kunststofffolie vor der Metallabscheidung einer Plasmavorbehandlung unterzogen wird, da auch dadurch die Haftfestigkeit der Metallschicht gewährleistet werden kann.

Eine weitere Möglichkeit zur Erreichung von Haftfestigkeit ohne Impfschicht wird in der DE 199 43 379 A1 in der Weise vorgeschlagen, dass während der Verdampfung des Metalls ein dichtes Plasma gezündet wird. Damit soll sowohl eine bessere Haftung als auch eine verbesserte Selbstheilung und ein geringerer Flächenwiderstand erreicht werden.

Die KR 01 415 09 beschreibt ein Verfahren zur Herstellung einer Zinkmetallschicht für einen Filmkondensator, bei welchem eine übliche Impf- bzw. Keimschicht aus Aluminium mittels eines Sputterverfahrens auf einer Kunststofffolie abgeschieden wird, um zusätzlich die Antioxidationseigenschaften zu verbessern.

### Darstellung der Erfindung

### Technische Aufgabe

Es ist Aufgabe der vorliegenden Erfindung ein Verfahren sowie eine mit dem Verfahren hergestellte, metallisierte Kunststofffolie bereitzustellen, welches besonders gut haftende Metallschichten mit guten Selbstheilungseigenschaften und Flächenwiderständen bei effektiver und insbesondere schneller Fertigung ermöglicht, wobei die Metallschichten eben und gleichmäßig ausgebildet sein sollen.

### Technische Lösung

Diese Aufgabe wird gelöst mit einem Verfahren mit den Merkmalen des Anspruchs 1 und einer Kunststofffolie mit den Merkmalen des Anspruchs 16. Vorteilhafte Ausgestaltungen sind Gegenstand der abhängigen Ansprüche.

Obwohl mit den bekannten, oben vorgestellten Verfahren nach dem Stand der Technik bereits gute Ergebnisse erzielt werden können, haben die Erfinder herausgefunden, dass eine weitere Optimierung der teilweise konkurrierenden Vorteile und Eigenschaften zu einem ausgewogenen Vorteil- und Eigenschaftsprofil möglich ist, wenn eine Kombination einer Plasmavorbehandlung mit der Abscheidung einer dünnen, insbesondere sehr dünnen Impf- bzw. Keimschicht vor dem Aufbringen des eigentlichen Metallfilms vorgenommen wird.

Insbesondere ist wesentlich, dass keine übliche Impfschicht mit den entsprechenden Ausmaßen, was die Dicke anbelangt, aufgebracht wird, sondern nur eine äußerst abgespeckte Impfschicht mit einer Dicke von einigen wenigen Atomlagen im nm-Bereich.

Entsprechend umfasst die Impfschicht einen Anteil der Gesamtschicht von < 5%, insbesondere < 3%, vorzugsweise ≤ 1%.

Vorzugsweise wird die Impfschicht durch Kathodenzerstäubung (Sputtern) aufgebracht, da sich dieses Verfahren bezüglich der Kombination von Plasmabehandlung und Abscheidung sehr dünner Schichten besonders gut eignet.

Um die Schichten mit sehr geringer Dicke abzuscheiden, ist es vorteilhaft, die Impfschicht mit einer niedrigen Abscheiderate abzuscheiden, da dann in Kombination mit der entsprechenden Transportgeschwindigkeit für die zu beschichtende Bahn in geeigneter Weise sehr dünne Impfschichten bis hin zu nicht mehr durchgehenden Schichten, die lediglich aus einer Anzahl von Insellagen bestehen, möglich sind.

Entsprechend ist es vorteilhaft die Kathodenspannung beim Sputterprozess im Bereich von einigen 100 V zu wählen, insbesondere unter 1000 V, vorzugsweise unter 500 V und höchst vorzugsweise im Bereich von ca. 400 V.

Entsprechend kann auch die Plasmaleistung < 15 kW bzw. ≤ 10 kW gewählt werden.

Der Druck bei der Abscheidung der Impfschicht ist vorzugsweise < 10⁻¹ hPa, insbesondere < 5 x 10⁻² hPa und vorzugsweise im Bereich von 10⁻² hPa. Auch damit lassen sich entsprechend niedrige Abscheide- bzw. Sputterraten erzielen.

Obwohl vorzugsweise die Atmosphäre während der Abscheidung der Impfschicht durch ein Inertgas und insbesondere Argonatmosphäre gebildet wird, kann es vorteilhaft sein, einen gewissen Anteil an Sauerstoff der Atmosphäre beizufügen, so dass der Reinigungseffekt der Oberfläche durch die Plasmabehandlung aufgrund der im Plasma vorhandenen Sauerstoffionen, die mit Verunreinigungen auf der Substratoberfläche reagieren, möglich wird. Die entsprechenden Reaktionsprodukte können dann über Vakuumpumpen zur Erzeugung der entsprechenden Druckverhältnisse aus der Reaktionskammer entfernt werden.

Nach einem weiteren vorteilhaften Aspekt der vorliegenden Erfindung, für den auch unabhängig Schutz beansprucht wird, kann durch das erfindungsgemäße Verfahren ein Material mit niedriger Sputterrate eingesetzt werden, insbesondere bei den metallischen Werkstoffen Stahl oder Edelstahl. Auf diese Weise ist für das Sputtertarget eine lange Lebensdauer gewährleistet und die Haftung und gleichmäßige Ausbildung der Metallschicht bzw. insbesondere Zinkschicht auf der Kunststoffoberfläche kann durch einen geringen Materialeinsatz gewährleistet werden.

Neben Stahl oder Edelstahl, welche bevorzugt im Zusammenhang mit der Aufbringung von Zink sind, können auch andere Materialien für die Impfschicht gewählt werden, wie beispielsweise Eisen, Silber, Aluminium, Kupfer, Gold oder Legierungen daraus.

Bei dem erfindungsgemäßen Verfahren kann das zu beschichtende Bandmaterial mit einer hohen Geschwindigkeit von bis zu 20 Metern pro Sekunde, vorzugsweise bis zu 25 Metern pro Sekunde an der Plasmaquelle bzw. dem Sputtertarget bei der Dampf- oder Gasphasenabscheidung der Impfschicht vorbeigeführt werden, da lediglich nur sehr dünne Impfschichten aufgetragen werden müssen. Dies erhöht die Effektivität des Verfahrens.

Die nachfolgende Abscheidung der eigentlichen Metallschicht und insbesondere der Zinkschicht kann durch jedes bekannte und geeignete Verfahren durchgeführt werden, insbesondere durch thermische Verdampfung des Zinks aus einer Zinkschmelze.

Die mit dem erfindungsgemäßen Verfahren hergestellten metallisierten Kunststofffolien, für welche nach einem weiteren Aspekt ebenfalls unabhängig Schutz begehrt wird, zeichnen sich dadurch aus, dass zwischen der Kunststofffolie und der Metallschicht eine Impfschicht mit sehr geringer Dicke im Bereich von einigen wenigen Atomlagen vorgesehen ist. Nach einem weiteren Aspekt der Erfindung ist bei einer Zink-Metallschicht vorzugsweise eine Impfschicht aus Stahl oder Edelstahl vorgesehen.

Die Kunststofffolie kann insbesondere aus Polyester oder Polypropylen gebildet sein.

### Kurze Beschreibung der Zeichnungen

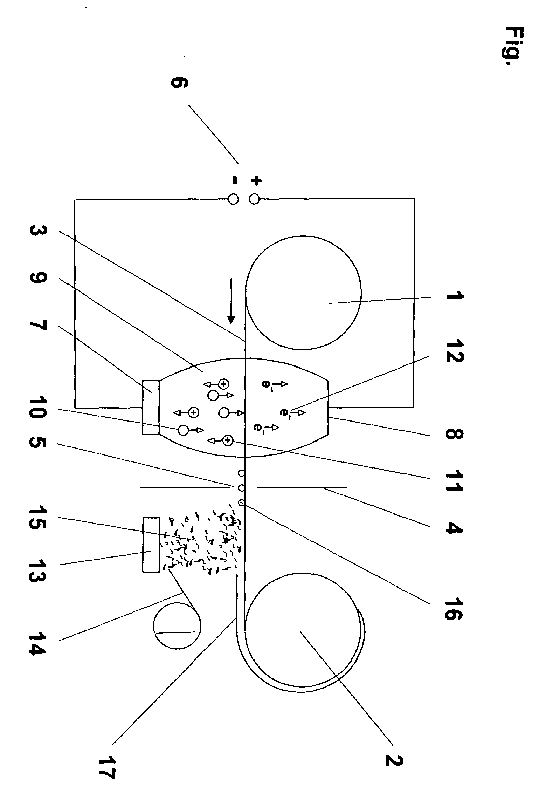

Weitere Vorteile, Kennzeichen und Merkmale der vorliegenden Erfindung werden bei der nachfolgenden detaillierten Beschreibung eines Ausführungsbeispiels anhand der beigefügten Zeichnung deutlich. Die Zeichnung zeigt in rein schematischer Weise in der einzigen beigefügten Figur eine Schemadarstellung einer Beschichtungsanlage für die Metallisierung von Kunststoffbahnen, insbesondere zur Herstellung von Kondensatorfolien.

### Bester Weg zur Ausführung der Erfindung

Die Figur zeigt eine rein schematische Darstellung, bei welcher die Anordnung der Komponenten nur zur Verdeutlichung des zugrunde liegenden Prinzips gewählt worden ist, aber von den tatsächlichen Gegebenheiten deutlich abweichen kann.

Die Beschichtungsanlage weist zwei Rollen 1 und 2 auf, wobei von der ersten Rolle 1 zu beschichtendes Kunststoffmaterial in Form einer Folie 3 entsprechend dem bei der Rolle 1 angegebenen Pfeil abgewickelt und in Richtung Rolle 2 geführt wird, wo die Folie 3 entsprechend wieder aufgewickelt wird.

Zwischen den beiden Rollen 1 und 2 sind zwei Beschichtungs- bzw. Behandlungsstationen angeordnet, die vorzugsweise durch eine Kammerwand 4 voneinander getrennt sind, wobei an der Kammerwand 4 ein Schlitz 5 oder eine Schleusenanordnung vorgesehen ist, durch welche hindurch die Folienbahn 3 geführt werden kann.

Die erste Beschichtungs- bzw. Behandlungsstation weist eine Kathode 7, eine Anode 8 und eine Gleichstromquelle bzw. Spannungsversorgung 6 auf, deren negativer Pol mit der Kathode und deren positiver Pol mit der Anode 8 verbunden sind. Durch Anlegen einer Gleichspannung im Bereich von einigen 100 V, insbesondere 400 V wird zwischen der Anode 8 und der Kathode 7 bei einer eingestellten Argonatmosphäre mit einem Druck von 10⁻² hPa und Magnetfeldunterstützung ein Plasma 9 gezündet.

Es ist für den Fachmann selbstverständlich, dass um die in der Figur gezeigte Anordnung ein entsprechendes Gehäuse oder eine Vakuumkammer (nicht gezeigt) vorgesehen ist.

Die Wickelanordnung mit der Rolle 1 sowie die Anode 8 und die Kathode 7 befinden sich somit in einer ersten Vakuumarbeitskammer, bei welcher im Bereich der ersten Beschichtungsstation mit der Elektrodenanordnung aus Kathode 7 und Anode 8 ein Druck im Bereich von 10⁻² hPa eingestellt wird. Als Arbeitsgas wird in die erste Vakuumkammer Argon eingebracht, so dass bei Zündung des Plasmas 9 positiv geladenen Argonionen 11 entstehen, die in Richtung der Kathode 7 beschleunigt werden.

Die Kathode 7 weist ein Zerstäubungsmaterial auf oder ist aus einem derartigen gefertigt, nämlich insbesondere Edelstahl. Durch die auftreffenden Argonionen wird das Zerstäubungsmaterial (Sputtertarget) zerstäubt, so dass Zerstäubungsmaterial 10 auf die Folie 3 gelangen kann, um sich dort anzulagern.

Gleichzeitig bewegen sich die negativ geladenen Elektronen 12 in Richtung der Anode 8, so dass sie sich zum Teil ebenfalls an der Folie 3 anlagern. Die Folie 3 aus einer Kunststoffbahn, die nicht leitfähig ist, wird dadurch in gewissem Umfang aufgeladen, so dass Ionen aus dem Plasma 9 auch auf die Folienoberfläche 3 auftreffen und durch das Ionenbombardement zu einer Reinigung und Aktivierung der Kunststofffolienoberfläche beitragen. Durch einen Zusatz von einem Anteil an Sauerstoff zur Atmosphäre kann die Reinigungswirkung noch erhöht werden.

Auf diese Weise wird in der ersten Beschichtungsstation eine Impfschicht 16, die auch als Keimschicht bezeichnet werden kann, auf der Folie 3 abgeschieden, welche aus dem Material des Sputtertargets bzw. der Kathode 7 besteht und vorzugsweise Edelstahl ist.

Da Edelstahl jedoch ein Material mit sehr geringer Zerstäubungsrate (Sputterrate) ist und die Geschwindigkeit, mit der die Kunststofffolienbahn 3 durch die Wickeleinrichtung 1, 2 durch das Plasma 9 hindurch bzw. an dem Sputtertarget vorbei bewegt wird, scheidet sich lediglich eine sehr dünne Impfschicht 16 in der Größenordnung von wenigen Atomlagen bis zu einigen nm ab. Dies wird noch dadurch verstärkt, dass die Spannung der Spannungsversorgung 6 mit einigen 100 V entsprechend niedrig gewählt wird.

Allerdings bewirkt die Abscheidung einer wenn auch sehr dünnen, in der beschichteten Folie kaum feststellbaren Impfschicht unter gleichzeitiger Einwirkung eines Plasmas, dass die nachfolgende Metallisierung in der zweiten Beschichtungsstation bzw. Reaktionskammer mit einer guten Haftung abgeschieden werden kann. Insbesondere durch das Kathodenzerstäuben (Sputtern) bei dem in einfacher Weise eine Materialabscheidung mit gleichzeitiger Plasmaeinwirkung auf das zu beschichtende Substrat erfolgt, kann der Aufwand für eine getrennte Plasmavorbehandlung und nachfolgende Aufbringung einer Impf- bzw. Keimschicht reduziert sowie die Impf- bzw. Keimschicht insgesamt stark verringert werden.

Nach Durchlaufen der ersten Beschichtungsstation mit Sputtern einer sehr dünnen Impf- bzw. Keimschicht 16 auf die zu beschichtende Kunststofffolienbahn 3 passiert die Kunststofffolienbahn die zweite Beschichtungsstation, bei der die abzuscheidende Metallschicht, vorzugsweise aus Zink über thermische Verdampfung aufgebracht wird. Hierzu ist ein Verdampfungstiegel 13 vorgesehen, der in einer geeigneten Weise, z.B. durch eine elektrische Widerstandsheizung beheizt wird, um das Zinkmaterial zu verdampfen. Die dadurch entstehende Zinkwolke 15, durch die hindurch die Kunststofffolienbahn 3 geführt wird, führt dazu, dass sich auf der Kunststofffolie 3 oberhalb der Impf- bzw. Keimschicht 16 die gewünschte Metallschicht 17 ausbildet.

Aufgrund der Plasmabehandlung und der Aufbringung einer dünnen Keim- bzw. Impfschicht 16 ist die Haftung des Zinkmaterials auf der Kunststofffolie sehr gut, gleichwohl die Impf- bzw. Keimschicht 16 nur eine sehr geringe Dicke aufweist. Dies hat jedoch den Vorteil, dass die Selbstheilungseigenschaften des Zinks durch die Impf- bzw. Keimschicht 16 nicht oder zumindest weniger stark als beim Stand der Technik beeinträchtigt werden. Gleichzeitig kann bei hoher Beschichtungsgeschwindigkeit, beispielsweise bei Transportgeschwindigkeiten der Kunststofffolienbahn 3 im Bereich von einigen Metern pro Sekunde, beispielsweise 6 Metern pro Sekunde bis zu 20 oder 25 Metern pro Sekunde mit einfachen Mitteln eine optimale Ablagerung der Metallschicht, beispielsweise einer Zinkschicht mit insbesondere sehr gleichmäßiger Ablagerung erzielt werden.

Obwohl die vorliegende Erfindung anhand einer bevorzugten Ausführungsform erläutert worden ist, ist für den Fachmann selbstverständlich, dass im Rahmen der beigefügten Patentansprüche, die den Schutzbereich definieren, Abwandlungen oder Änderungen möglich sind, ohne dass der Schutzbereich verlassen wird. Insbesondere können einzelne Merkmale weggelassen oder in unterschiedlicher Art und Weise miteinander kombiniert werden.

## Patentansprüche

1. Verfahren zur Herstellung metallisierter Bahnen, insbesondere metallisierter Kunststoffbahnen für Folienkondensatoren, bei welchem eine Metallschicht (17) über eine Dampf- oder Gasphase auf eine Bahn (3) aufgebracht wird, wobei vor dem Aufbringen der Metallschicht mittels einer plasmaunterstützten Dampf- oder Gasphasenabscheidung eine metallische Impfschicht (16) auf der Bahn (3) aufgebracht wird,
**dadurch gekennzeichnet, dass** die Dicke der lmpfschicht maximal einige wenige Atomlagen beträgt.

2. Verfahren nach Anspruch 1 oder nach dem Oberbegriff des Anspruchs 1,
**dadurch gekennzeichnet, dass** die Impfschicht (16) einen Anteil an der Gesamtschicht von kleiner 5%, insbesondere kleiner 3%, vorzugsweise kleiner oder gleich 1 % aufweist.

3. Verfahren nach einem der vorhergehenden Ansprüche,
**dadurch gekennzeichnet, dass** die plasmaunterstützte Dampf- oder Gasphasenabscheidung der metallischen Impfschicht durch Kathodenzerstäubung (Sputtern) erfolgt.

4. Verfahren nach einem der vorhergehenden Ansprüche,
**dadurch gekennzeichnet, dass** die Impfschicht mit niedriger Abscheiderate abgeschieden wird.

5. Verfahren nach einem der vorhergehenden Ansprüche,
**dadurch gekennzeichnet, dass** das Plasma bei der Abscheidung der Impfschicht mit niedriger Kathodenpannung, insbesondere unter 1000 V, vorzugsweise unter 500 V, höchst vorzugsweise mit ca. 400 V betrieben wird.

6. Verfahren nach einem der vorhergehenden Ansprüche,
**dadurch gekennzeichnet, dass** das Plasma mit einer Leistung kleiner 15 kW, insbesondere kleiner oder gleich 10 kW erzeugt wird.

7. Verfahren nach einem der vorhergehenden Ansprüche,
**dadurch gekennzeichnet, dass** der Druck bei der Abscheidung der Impfschicht kleiner 10⁻¹ hPa, insbesondere kleiner 5 x 10⁻² hPa, vorzugsweise im Bereich von 10⁻² hPa ist.

8. Verfahren nach einem der vorhergehenden Ansprüche,
**dadurch gekennzeichnet, dass** die Abscheidung der Impfschicht im Wesentlichen unter Ar-Atmosphäre erfolgt.

9. Verfahren nach einem der vorhergehenden Ansprüche,
**dadurch gekennzeichnet, dass** die Abscheidung der Impfschicht unter Zusatz von Sauerstoff zur Atmosphäre erfolgt.

10. Verfahren nach einem der vorhergehenden Ansprüche oder dem Oberbegriff des Anspruchs 1,
**dadurch gekennzeichnet, dass** die Impfschicht aus einem Material mit niedriger Sputterrate, insbesondere Stahl oder Edelstahl abgeschieden wird.

11. Verfahren nach einem der vorhergehenden Ansprüche,
**dadurch gekennzeichnet, dass** das Material für die Impfschicht ausgewählt ist aus der Gruppe, die Eisen, Silber, Aluminium, Kupfer, Gold oder Legierungen davon, insbesondere Stahl, vorzugsweise Edelstahl umfasst.

12. Verfahren nach einem der vorhergehenden Ansprüche,
**dadurch gekennzeichnet, dass** die Metallschicht Zink umfasst.

13. Verfahren nach einem der vorhergehenden Ansprüche,
**dadurch gekennzeichnet, dass** die Impfschicht und die Metallschicht unterschiedliche Zusammensetzungen aufweisen.

14. Verfahren nach einem der vorhergehenden Ansprüche,
**dadurch gekennzeichnet, dass** das zu beschichtende Bandmaterial mit einer Geschwindigkeit von bis zu 20 m/s, vorzugsweise bis zu 25 m/s an der Plasmaquelle oder einem Sputtertarget der plasmaunterstützten Dampf- oder Gasphasenabscheidung der Impfschicht vorbeigeführt wird.

15. Verfahren nach einem der vorhergehenden Ansprüche,
**dadurch gekennzeichnet, dass** die Abscheidung der Metallschicht durch thermisches Verdampfen erfolgt.

16. Metallisierte Kunststofffolie, insbesondere Folienkondensator, vorzugsweise hergestellt nach einem Verfahren gemäß der vorhergehenden Ansprüche, welche mindestens eine Kunststofffolie umfasst, auf welcher mindestens eine Metallschicht und eine zwischen Metallschicht und Kunststofffolie vorgesehene Impfschicht angeordnet ist,
**dadurch gekennzeichnet, dass** die Impfschicht maximal bis zu einigen wenigen Atomlagen dick ist.

17. Kunststofffolie nach Anspruch 16,
**dadurch gekennzeichnet, dass** die Kunststofffolie aus Polyester oder Polypropylen ist.

18. Kunststofffolie nach Anspruch 16 oder 17 oder dem Oberbegriff des Anspruch 16,
**dadurch gekennzeichnet, dass** die Metallschicht Zink und die Impfschicht Stahl oder Edelstahl umfasst.

19. Kunststofffolie nach einem der Ansprüche 16 bis 18,
**dadurch gekennzeichnet, dass** das Material für die Impfschicht ausgewählt ist aus der Gruppe, die Eisen, Silber, Aluminium, Kupfer, Gold oder Legierungen davon, insbesondere Stahl, vorzugsweise Edelstahl umfasst.
